# EUROPEAN PATENT SPECIFICATION

(11) **EP 1 377 394 B1**
(45) Date of publication and mention of the grant of the patent: **19.12.2007**
(21) Application number: 01926158.5
(22) Date of filing: 08.05.2001
(51) Int. Cl.: B08B 7/00

(54) **LABEL SHEET FOR CLEANING, METHOD OF MANUFACTURING A LABEL SHEET, CONVEYING MEMBER HAVING CLEANING FUNCTION AND METHOD OF CLEANING A SUBSTRATE PROCESSING EQUIPMENT**
ETIKETTENBLATT ZUM REINIGEN, VERFAHREN ZUR HERSTELLUNG EINES ETIKETTENBLATTS, FÖRDERELEMENT MIT REINIGUNGSFUNKTION UND VERFAHREN ZUM REINIGEN EINER SUBSTRATBEARBEITUNGSSSTATION
FEUILLE D'ETIQUETTES POUR NETTOYER, PROCÉDÉ DE FABRIQUER UNE FEUILLE D'ETIQUETTES, CONVOYEUR AYANT UNE FONCTION DE NETTOYAGE ET MÉTHODE DE NETTOYER UNE STATION DE TRAITEMENT D'UN SUBSTRAT

(30) Priority: 09.04.2001 JP 2001109405; 10.04.2001 JP 2001111791
(43) Date of publication of application: 07.01.2004
(73) Proprietor: NITTO DENKO CORPORATION, Ibaraki-shi, Osaka 567-0041 (JP)
(72) Inventor: NAMIKAWA, Makoto, Nitto Denko Corporation, Ibaraki-shi, Osaka 567-0041 (JP); TERADA, Yoshio, Nitto Denko Corporation, Ibaraki-shi, Osaka 567-0041 (JP); NUKAGA, Jirou, Nitto Denko Corporation, Ibaraki-shi, Osaka 567-0041 (JP); TOYODA, Eiji, Nitto Denko Corporation, Ibaraki-shi, Osaka 567-0041 (JP)
(74) Representative: Grünecker, Kinkeldey, Stockmair & Schwanhäusser Anwaltssozietät
(86) International application number: PCT/JP2001/003850
(87) International publication number: WO 2002/083332

(56) References cited:
- EP-A- 0 930 538
- WO-A-00/67924
- US-A- 6 126 772
- PATENT ABSTRACTS OF JAPAN vol. 1998, no. 11, 30 September 1998 (1998-09-30) -& JP 10 154686 A (TOSHIBA CORP), 9 June 1998 (1998-06-09) cited in the application
- PATENT ABSTRACTS OF JAPAN vol. 1999, no. 13, 30 November 1999 (1999-11-30) -& JP 11 224414 A (NITTO DENKO CORP), 17 August 1999 (1999-08-17)

## Description

### Technical Field

The present invention relates to a label sheet for cleaning various equipments, and a label sheet for cleaning and a conveying member having a cleaning function for a substrate processing equipment which hates foreign matters, for example, a manufacturing equipment or a checking equipment for a semiconductor, a flat panel display or a printed board.

### Background Art

US-A-6126772 discloses a method for resist removal from an article, in particular a silicon wafer, comprising a substrate and an adhesive layer formed thereon. The adhesive layer for removal of the resist from an article is beforehand formed on a substrate, to produce an adhesive sheet in the form of a sheet, tape or the like and this adhesive sheet is applied to the article. For resist removal the adhesive sheet, wherein the adhesive is only provided on one side of the substrate, is supplied to the article and is peeled together with a resist from the article. With respect to the adhesive which is used, it is disclosed that the 180 peel adhesive strings between the adhesive layer and the resist being removed and needs to be regulated to approximately 5g/10mm or higher, especially about 5-5,000g/10mm.

Furthermore, WO-A-00 677924 discloses a cleaning apparatus as well as a method for cleaning and decontaminating the internal work component of electronic equipment. In particular the cleaning apparatus comprises a base material having a first and second surface, wherein cleaning substrate is disposed on one surface and an adhesive substrate is disposed on one of the first and second surfaces. The described cleaning apparatus is conveyed along a predetermined media path and has a smaller shape than the conveying member.

Various substrate processing equipments convey each conveying system and a substrate in physical contact with each other. In that case, if foreign matters stick to the substrate or the conveying system, succeeding substrates are successively contaminated. Therefore, it is necessary to periodically stop the equipment and to carry out a washing process. For this reason, there is a problem in that an availability factor is reduced and a great deal of labor is required. In order to solve the problem, there have been proposed a method of removing foreign matters sticking into a substrate processing equipment through cleaning by conveying a substrate having an adhesive substance fastened thereto (for example, Unexamined Japanese Patent Publication 10-154686) and a method of removing foreign matters sticking to the back face of a substrate by conveying a plate-shaped member (Unexamined Japanese Patent Publication 11-87458).

The method of removing foreign matters sticking into a substrate processing equipment through cleaning by conveying a substrate having an adhesive substance fastened thereto is effective for solving the problem described above. According to this method, however, there is a possibility that the adhesive substance and a contact portion in the equipment might be bonded too strongly to be removed. Therefore, the substrate might not be conveyed reliably. Inparticular, in the case in which a pressure reducing absorption mechanism is used for a chuck table of the equipment, this problem is remarkable.

Moreover, the method of removing foreign matters by conveying a plate-shaped member can carry out the conveyance without a hindrance but has a deterioration in a dust cleaning property which is important.

Furthermore, in the case in which a cleaning sheet having a greater size than the size of the substrate is bonded to the substrate and is then cut along the shape of the substrate, a cutting step is further required and a cut refuse generated by the cutting might stick to the substrate or an equipment.

Referring to a method of manufacturing the conveying member having a cleaning function, moreover, there has been known a method of bonding a larger cleaning sheet than the conveying member and then cutting the cleaning sheet along the shape of the member when bonding a cleaning sheet to a conveying member such as a substrate to manufacture the conveying member for cleaning, for example (which will be hereinafter referred to as a direct cutting method). In such a method, a cut refuse might be generated from a cleaning layer and might stick to the cleaning member or an equipment during sheet cutting. In a method of bonding a label sheet for cleaning previously punched to have the shape of the conveying member to the conveying member, thereby manufacturing the conveying member for cleaning (which will be hereinafter referred to as a precutting method), moreover, the generation of the cut refuse during the sheet punching is more reduced than that in the direct cutting method. In some cases, however, an adhesive of the cleaning layer might leak out of a punched surface during the sheet punching and might stick to an end of the label so that appearance is deteriorated due to defective punching or conveyance troubles are made. In the case in which an adhesive of a polymerization and curing type is used, furthermore, the adhesive on the end of the label causes defective curing by polymerization inhibition due to oxygen inhibition if the curing is to be carried out after the sheet punching. Therefore, the contact portion of the substrate processing equipment might be contaminated by the adhesive.

### Disclosure of Invention

In order to achieve the object described above, the inventors made investigations earnestly. As a result, they found that when the cleaning sheet or the substrate having the sheet fastened thereto is conveyed to remove foreign matters sticking into the substrate processing equipment through cleaning, an adhesion is set to have a specific value or less with an active energy source as the cleaning layer and the cleaning sheet is set to have the label shape, resulting in removal in the foreign matters more easily and reliably without making the troubles described above. Thus, they have completed the invention.

In order to achieve the object described above, furthermore, the inventors made investigations earnestly. As a result, they found that it is possible to provide a conveying member having a cleaning function capable of removing foreign matters more easily and reliably without making the troubles by setting the shape of the cleaning sheet to be smaller than that of the conveying member. Thus, they have completed the invention.

In consideration of such circumstances, moreover, it is an object of the invention to provide a label sheet for cleaning which can reliably convey a substrate into a substrate processing equipment, can remove foreign matters sticking into the equipment easily and reliably, and furthermore, can enhance a working efficiency and can generate no cut refuse because sheet cutting is not required after bonding to the substrate.

In consideration of such circumstances, it is another object of the invention to provide a method of manufacturing a label sheet having a cleaning function which can reliably convey a substrate into a substrate processing equipment, can remove foreign matters sticking into the equipment easily and reliably, and furthermore, causes neither defective punching during sheet punching nor defective adhesive curing in a precutting method.

More specifically, the invention relates according to claim 1 to a label sheet for cleaning a substrate processing equipment comprising: a layer for cleaning including a cleaning layer having a 180° peeling adhesion to a silicon wafer (mirror surface) of a 0,20 N/10mm or less after receiving an active energy and an adhesive provided on one of the surfaces of said cleaning layer, and a separator on which the label is removably provided through said adhesive layer. The label sheet also may be constituted such that the cleaning layer is provided on one of surfaces of a base material and an ordinary adhesive layer is provided on the other surface. A plurality of labels for cleaning may be continuously provided on an elongated separator at regular intervals.

The invention also relates according to claim 9 to a conveying member having a cleaning function comprising the label sheet for cleaning on the conveying member, wherein the label sheet for cleaning has a smaller shape than that of the conveying member and is not protruded from an end of the conveying member.

The invention also relates according to claim 15 to a method of manufacturing the label sheet for cleaning in which a cleaning layer formed of an adhesive is provided on one of surfaces of a base material thereof protected by a removing film and the other surface is removably provided on a separator through an ordinary adhesive layer, wherein the cleaning layer is a curing type adhesive which is polymerized and cured upon receipt of an active energy and the step of punching a sheet to have a shape of the label is carried out after a polymerization and curing reaction of the adhesive of the cleaning layer.

Features and advantages of the invention will be evident from the following detailed description of the preferred embodiments described in conjunction with the attached drawings.

### Brief Description of Drawings

Fig. 1 is a partial plan view showing an example of a label sheet for cleaning according to the invention;
Fig. 2 is a sectional view taken along a line II - II in Fig. 1;
Fig. 3 is a partial plan view showing anther example of the label sheet for cleaning according to the invention;
Fig. 4 is a partial plan view showing yet another example of the label sheet for cleaning according to the invention;
Fig. 5 is a partial plan view showing a further example of the label sheet for cleaning according to the invention;
Fig. 6 is a sectional view showing an example of a conveying member having a cleaning function according to the invention;
Fig.7 is a partial plan view showing an example of the label sheet for cleaning according to the invention; and
Fig. 8 is a sectional view taken along a line VIII - VIII in Fig. 7.

### Best Mode for Carrying Out the Invention

In a label sheet for cleaning according to the invention, a cleaning layer (which will hereinafter include such a configuration as a single cleaning sheet, a laminated sheet or a laminated sheet with a base material) is cured by an active energy source, resulting in a reduction in an adhesion. A 180° peeling adhesion to a silicon wafer (mirror surface) is 0.20 N / 10 mm or less, and preferably approximately 0.010 to 0.10 N /10 mm. When the adhesion exceeds 0.20 N / 10 mm, the cleaning layer might be bonded to a portion to be cleaned in the equipment during conveyance to make conveyance troubles. The active energy source includes ultraviolet rays and heat to be used for the curing and the ultraviolet rays are preferable. Moreover, while the thickness of the cleaning layer is not particularly restricted, it is usually set to be approximately 5 to 100 µm.

In the invention, furthermore, it is desirable that the cleaning layer should have a modulus of tensile elasticity (in accordance with a test method JIS K7127) of 0.98 N / mm² or more and preferably 9.8 to 980 N / mm². If the modulus of tensile elasticity is set to have such a specific value or more, a substrate in a substrate processing equipment can be conveyed more reliably.

In the invention, furthermore, it is desirable that the cleaning layer should have a surface resistivity of 1 x 10¹³Ω / □ or more and particularly 1 x 10¹⁴Ω /□ or more. If the surface resistivity of the cleaning layer is set to such a specific value or more to maintain the cleaning layer to be an insulator as much as possible, it is possible to obtain the effect that foreign matters can be captured and adsorbed through static electricity in addition to the adhesion thereof. Accordingly, it is preferable that the cleaning layer should not include a conductive substance such as an additive having a conducting function.

For the cleaning layer according to the invention, a curing type adhesive which is polymerized and cured upon receipt of an active energy is preferably used. Consequently, tackiness of the cleaning layer is substantially eliminated so that the cleaning layer is not strongly bonded to the equipment contact portion when a conveying member having a cleaning function is to be conveyed. Thus, it is possible to provide the conveyingmemberhaving a cleaning function which can be conveyed reliably. The active energy source includes ultraviolet rays and heat and the ultraviolet rays are preferable.

As long as the cleaning layer has such a property that it is cured by the active energy source to cause a molecular structure to have a three-dimensional network, a material thereof is not particularly restricted. For example, it is preferable that the cleaning layer should be formed of an adhesive layer obtained by a pressure - sensitive adhesive polymer containing a compound having one or more unsaturated double bonds in a molecule. Examples of the pressure - sensitive adhesive polymer include an acryl based polymer containing, as a principal monomer, (metha)acrylic acid and/or (metha)acrylic ester selected from acrylic acid, acrylic ester, methacrylic acid and ester methacrylate. A compound having two or more unsaturated double bonds in a molecule is used as a copolymerized monomer in the synthesis of the acryl based polymer or a compound having an unsaturated double bond in a molecule is chemically bonded to the acryl based polymer with a reaction between functional groups after the synthesis so that the unsaturated double bond is introduced into the molecule of the acryl based polymer. Consequently, a polymer itself can also be related to a polymerization and curing reaction with an active energy.

It is preferable that a compound having one ormore unsaturated double bonds in a molecule (which will be hereinafter referred to as a polymerized and unsaturated compound) should be a low molecular weight compound which is nonvolatile and has a weight average molecular weight of 10000 or less, and particularly, should have a molecular weight of 5000 or less such that the three-dimensional network of an adhesive layer can be obtained efficiently during curing.

It is preferable that the polymerized and unsaturated compound should be a low molecular weight compound which is nonvolatile and has a weight average molecular weight of 10000 or less, and particularly, should have a molecular weight of 5000 or less such that the three-dimensional network of the cleaning layer can be obtained efficiently during curing. Examples of such a polymerized compound include phenoxypolyethyleneglycol (metha)acrylate, ε -caprolacton (metha)acrylate, polyethyleneglycol di(metha)acrylate, polypropyleneglycol di(metha)acrylate, trimethylolpropane tri(metha)acrylate, dipentaerythritolhexa(metha)acrylate,urethane(metha)acrylate, epoxy (metha) acrylate and oligoester (metha) acrylate, and one or more of them are used.

Moreover, a polymerization initiator to be added to the adhesive layer is not particularly restricted and a well-known polymerization initiator can be used. For example, in the case in which heat is used for the active energy source, a thermal polymerization initiator such as benzoyl peroxide or azobisisobutylonitoryl is applied. In the case in which light is used for the active energy source, a photopolymerization initiator such as benzoyl, benzoyl ethylether, dibenzyl, isopropylbenzoyl ether, benzophenone, Michler's ketone chlorothioxanthone, dodecylthioxanthone, dimethylthioxanthone, acetophenone diethylketal, benzyldimethylketal, α -hydroxycyclohyxyl phenylketone, 2-hydroxydimethyl phenylpropane or 2,2-dimethoxy-2-phenylacetophenone.

While the base material is not particularly restricted, examples thereof include a plastic film such as polyethylene, polyethylene terephthalate, acetyl cellulose, polycarbonate, polypropylene or polyamide. A thickness of the base material is usually set to approximately 10 to 100 µm.

The label sheet for cleaning according to the invention comprises a label for cleaning including the specific cleaning layer on one of surfaces of a base material and an ordinary adhesive layer on the other surface which is removably provided on a separator through the ordinary adhesive layer. As long as the adhesive layer on the other surface side satisfies the adhesion function, a material thereof is not particularly restricted and an ordinary adhesive (for example, an acryl based adhesive or a rubber based adhesive) canbe used. With such a structure, the label for cleaning is removed from a separator which will be described below, is bonded to a conveying member such as various substrates through the ordinary adhesive layer and is conveyed as a conveying member having a cleaning function into the equipment to come in contact with a portion to be washed. Thus, the cleaning can be carried out.

While the conveying member to which the label for cleaning is to be bonded is not particularly restricted, examples of the conveying member include a substrate for a flat panel display such as a semiconductor wafer, an LCD or a PDP and a substrate such as a compact disk or an MR head.

In the invention, in the case in which the substrate is to be removed from the adhesive layer after the cleaning in order to recycle the conveying member such as the substrate, it is especially preferable that the ordinary adhesive layer should have a 180° peeling adhesion for a silicon wafer (mirror surface) of approximately 0.01 to 0.98 N/10 mm, and particularly, approximately 0.01 to 0.5 N / 10 mm, the substrate is not removed during the conveyance but can be easily removed again after the cleaning.

As long as the label for cleaning can be removed, the separator according to the invention is not particularly restricted and examples thereof include polyolefin such as polyester, polypropylene, polybutene, polybutadiene or polymethyl pentene which is removed with a silicone based, long chain alkyl based, fluorine based, fatty acid amide based or silica based remover, and a plastic film formed of polyvinyl chloride, vinyl chloride copolymer, polyethylene terephthalate, polybutylene terephthalate, polyurethane, ethylene-vinylacetate copolymer, ionomer resin, ethylene-(metha)acrylate copolymer, ethylene-(metha)acrylic ester compolyer, polystyrene or polycarbonate.

The invention will be described more specifically with reference to the drawings.

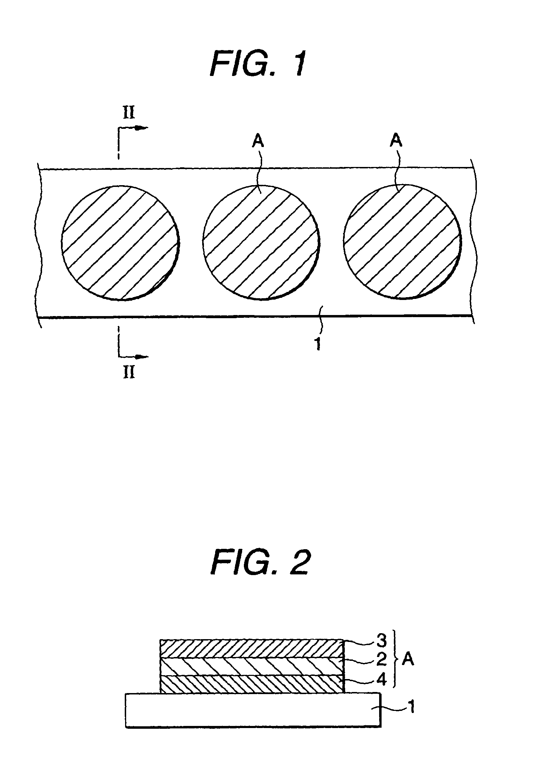

Fig. 1 is a plan view showing an example of a label sheet for cleaning according to the invention in which a plurality of labels A for cleaning are continuously provided on an elongated separator 1 at regular intervals. The label A includes a cleaning layer 3 on one of surfaces of a base material 2 and an ordinary adhesive layer 4 on the other surface as shown in Fig. 2 (a sectional view taken along a line II - II in Fig. 1) and is removaly provided on the separator 1 through the adhesive layer 4.

During use, the label for cleaning is removed from the separator 1, is bonded to a conveying member such as a semiconductor wafer and is conveyed into an equipment. Consequently, a portion to be washed can be cleaned.

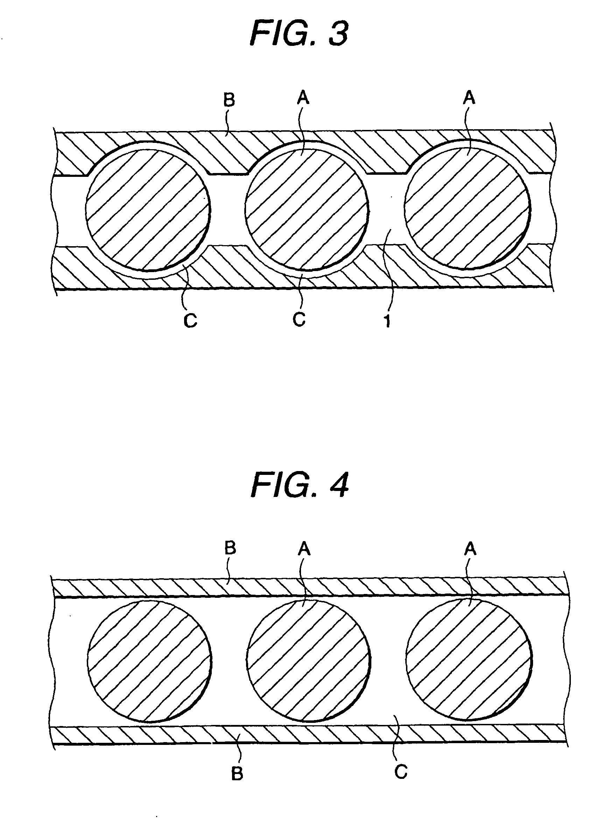

Fig. 3 is a plan view showing another example of the label sheet for cleaning according to the invention in which a reinforcing portion B is formed through a trench-shaped concave portion C over the whole periphery of the label A for cleaning. Since the reinforcing portion B is provided through the concave portion C, an excellent handling property can be obtained when the label sheet for cleaning is a roll-shaped substance or a sheet laminator and the label for cleaning can be smoothly removed from a separator during use so that an excellent labeling reliability can also be obtained. In the case in which the label sheet for cleaning is to be obtained through punching to have the shapes of the label and the reinforcing portion and by separating and removing an unnecessary part to be the concave portion C from the separator, it is preferable that the concave portions C are continuously provided each other because the unnecessary parts can be consecutively removed. As long as the unnecessary parts can be moved well, a part of the periphery of the label A is not the concave portion but may be only a nick portion such that the label A and the reinforcing portion B are provided partially in contact with each other.

As shown in Fig. 4, furthermore, the band-shaped reinforcing portion B can be continuously provided on both ends of the separator 1, that is, both ends in a transverse direction. The reinforcing portion B is formed linearly in parallel with the end of the separator. It is preferable that the reinforcing portion B and the label A on both sides or either side should be provided at regular intervals in a non-contact with each other because the unnecessary parts can be consecutively removed during the manufacture of the sheet. However, the reinforcing portion B and the label A on both sides can also be provided in contact with each other.

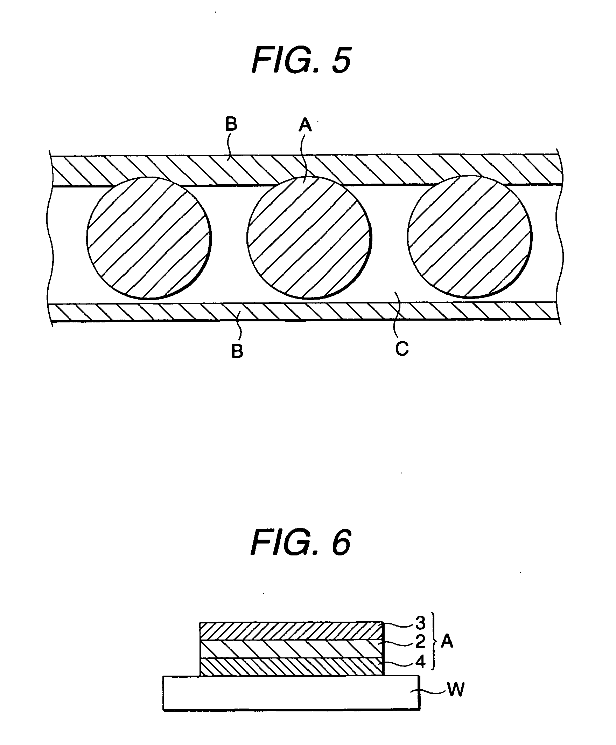

As shown in Fig. 5, moreover, the reinforcing portion B on either side is formed to have a great width such that the reinforcing portion B comes in contact with a part of the outer periphery of the label A. Consequently, it is possible to further enhance the effect of reinforcing the end of the label sheet without damaging the continuous removal of the unnecessary part.

While the shape of the reinforcing portion B is not particularly restricted but can be properly provided continuously or discontinuously, it is preferable that the reinforcing portion B should be provided continuously in respect of prevention of a refuse from entering through the end. Although the thickness of the reinforcing portion B is not particularly restricted, it is preferable that the thickness should be almost equal to that of the label A in consideration of the roll-shaped or laminated label sheet. Furthermore, the width of the reinforcing portion B is not particularly restricted and can be properly set in consideration of the width of the separator and the diameter of the label. If the width is set to be as great as possible, the reinforcing effect can be increased.

Moreover, the shape of the label A is not particularly restricted and a circular shape, a wafer shape, a frame shape, and furthermore, a shape having a protruded part for a chuck portion can be taken depending on the shape of the conveying member such as a substrate to be bonded, for example.

While a method of manufacturing the label sheet for cleaning according to the invention is not particularly restricted, for example, a laminator including a separator and an adhesive film is formed by a method of bonding an adhesive film constituting the label and the reinforcing portion (in which a cleaning layer is provided on one of surfaces of a base material and an ordinary adhesive layer is provided on the other surface) onto the separator. Next, only the adhesive film of the laminator is punched to have the shape(s) of the label and/or the reinforcing portion simultaneously or separately so that an unnecessary adhesive film can be separated and removed from the separator. In case of such a manufacturing method, it is preferable that the concave portion should be provided continuously because the unnecessary adhesive film can be removed consecutively. Then, the unnecessary adhesive film is usually wound onto an optional core to be roll-shaped.

In a second conveying member having a cleaning function according to the invention, the shape of a cleaning sheet should be smaller than that of the conveying member and the cleaning sheet is not protruded from the end of the conveying member. If the shape of the cleaning sheet is larger than that of the conveying member and is protruded from the conveying member, the cleaning sheet is caught in a conveying member accommodating cassette or a conveyance path so that it is turned over and shifted. In the worst case, there is a possibility that the conveyance might not be carried out. The label sheet might be caught in the conveying member accommodating cassette even if the shape of the cleaning sheet is the same as that of the conveying member. Only in the case in which the shape of the cleaning sheet is smaller than that of the conveying member, therefore, the conveying member having a cleaning function can be conveyed reliably. While the degree of smallness is not particularly restricted, an effective area required for removing foreign matters is reduced if the cleaning sheet is too small. Therefore, a size of approximately 5 mm is practically required at a minimum.

In a preferable cleaning sheet to be used, a cleaning layer is provided on one of the surfaces of the base material and the surface of the cleaning layer is protected by a removing film if necessary, and an ordinary adhesive layer is provided on the other surface. The cleaning sheet is provided on the conveying member through the ordinary adhesive layer.

The invention also provides a label sheet for cleaning which is to be used for the conveying member.

It is preferable that a label sheet for cleaning should have such a structure that a cleaning layer is provided on one of surfaces of a base material with a surface thereof protected by a removing film and the other surface is removably provided on a separator through an ordinary adhesive layer. Also in this case, a shape of the label is smaller than that of the conveyingmember. Moreover, it is preferable that a plurality of labels for cleaning should be continuously provided on an elongated separator at regular intervals.

While the method of manufacturing a label sheet for cleaning is not particularly restricted, it is preferable that a curing type adhesive for polymerizing and curing a cleaning layer upon receipt of an active energy should be used and the step of cutting the sheet to have the shape of the label should be carried out after the polymerization and curing reaction of the adhesive of the cleaning layer. If the adhesive constituting the cleaning layer is neither polymerized nor cured during the sheet cutting, an adhesive layer constituting the cleaning layer is protruded from a cut end and is bonded to a cut surface, the adhesive ropes, a cutting depth become nonuniform or a cut surface is roughened. In the worst case, defective cutting might be caused. Furthermore, when the polymerization and curing reaction is carried out after the sheet cutting, the adhesive facing a cut portion is inhibited from being polymerized due to oxygen inhibition. In some cases, consequently, the substrate processing equipment is contaminated by the adhesive.

In the invention, it is particularly desirable that the cleaning layer should have a modulus of tensile elasticity (in accordance with a test method JIS K7127) of 10 N / mm² or more and preferably 10 to 2000 N / mm² such that troubles are not made during the sheet cutting. If the modulus of tensile elasticity is set to have such a specific value or more, it is possible to more prevent the adhesive from leaking out of the cleaning layer or defective cutting from being caused during the sheet cutting. Thus, it is possible to manufacture a label sheet for cleaning which is not contaminated by the adhesive in the precutting method. If the modulus of tensile elasticity is smaller than 10N / mm², the troubles might be made during the sheet cutting or conveyance troubles might be made due to bonding of the adhesive to a portion to be cleaned in the equipment during the conveyance. On the other hand, if the modulus of tensile elasticity is too great, the performance for removing foreign matters sticking onto a conveying system might be deteriorated.

The cleaning layer is cured by an active energy source, resulting in a reduction in an adhesion. A 180° peeling adhesion to a silicon wafer (mirror surface) is 0.20 N / 10 mm or less, and preferably approximately 0.010 to 0.10 N / 10 mm. When the adhesion exceeds 0.20 N / 10 mm, the cleaning layer might be bonded to a portion to be cleaned in the equipment during conveyance to make conveyance troubles. Moreover, while the thickness of the cleaning layer is not particularly restricted, it is usually set to be approximately 5 to 100 µm.

When the method of manufacturing a label sheet for cleaning according to the invention is not particularly restricted, for example, a cleaning sheet comprising the cleaning layer including the specific adhesive on one of the surfaces of the base material with the surface thereof protected by a removing film and the other surface provided removably on a separator through an ordinary adhesive layer is caused to have the shape of a label through a processing of cutting the sheet other than the separator after a curing type adhesive acting as the cleaning layer is cured. In this case, the cutting method or the processing configuration is not particularly restricted. After punching is carried out in conformity with the shape of a conveying member which will be described below, an unnecessary sheet may be separated and removed to form a label. Moreover, it is possible to separate and remove an unnecessary sheet other than a label portion and a reinforcing portion with the sheet remaining as the reinforcing portion on the periphery of the label or on the end of the sheet apart from the label, thereby forming the label.

In the method of manufacturing a label sheet for cleaning, a cleaning sheet is used in which the specific cleaning layer is provided on one of surfaces of a base material and the other surface side is removably provided on a separator through an ordinary adhesive layer. As long as the adhesive layer on the other surface side satisfies the adhesion function, a material thereof is not particularly restricted and an ordinary adhesive (for example, an acryl based adhesive or a rubber based adhesive) can be used. With such a structure, the label sheet for cleaning is removed from a separator which will be described below, is bonded to a conveying member such as various substrates through the ordinary adhesive layer and is conveyed as a conveying member having a cleaning function into the equipment to come in contact with a portion to be washed. Thus, the cleaning can be carried out. In the case in which the conveying member is to be removed from the adhesive layer after the cleaning in order to recycle the conveying member such as the substrate, moreover, it is especially preferable that the ordinary adhesive layer should have a 180° peeling adhesion to a silicon wafer (mirror surface) of approximately 0.01 to 0.98 N / 10 mm, and particularly, approximately 0.01 to 0.5 N / 10 mm because the substrate is not removed during the conveyance but can be easily removed again after the cleaning.

While the base material supporting the cleaning layer is not particularly restricted, examples of the base material include a plastic film such as polyethylene, polyethylene terephthalate, acetylcellulose polycarbonate, polypropylene, polyimide, polyamide or polycarbodiimide. The thickness of the base material is usually set to approximately 10 to 100 µm.

As long as the label sheet for cleaning can be removed, the separator according to the invention is not particularly restricted and examples thereof include polyolefin such as polyester, polypropylene, polybutene, polybutadiene or polymethyl pentene which is removed with a silicone based, long chain alkyl based, fluorine based, fatty acid amide based or silica based remover, and a plastic film formed of polyvinyl chloride, vinyl chloride copolymer, polyethylene terephthalate, polybutylene terephthalate, polyurethane, ethylene-vinylacetate copolymer, ionomer resin, ethylene-(metha)acrylate copolymer, ethylene-(metha)acrylic ester compolyer, polystyrene or polycarbonate.

While the conveying member to which the label sheet for cleaning is to be bonded is not particularly restricted, examples of the conveying member include a semiconductor wafer, a substrate for a flat panel display such as an LCD or a PDP and a substrate such as a compact disk or an MR head.

The invention will be described more specifically with reference to the drawings.

Fig. 6 is a plan view showing an example of a conveying member having a cleaning function according to the invention in which a label A for cleaning is provided on a conveying member W such as a wafer so that the shape of the label A is smaller than that of the conveying member W and is not protruded from the end of the conveying member W. The label A includes a cleaning layer 3 on one of surfaces of a base material 2 and an ordinary adhesive layer 4 on the other surface, and is provided on the conveying member W through the adhesive layer 4.

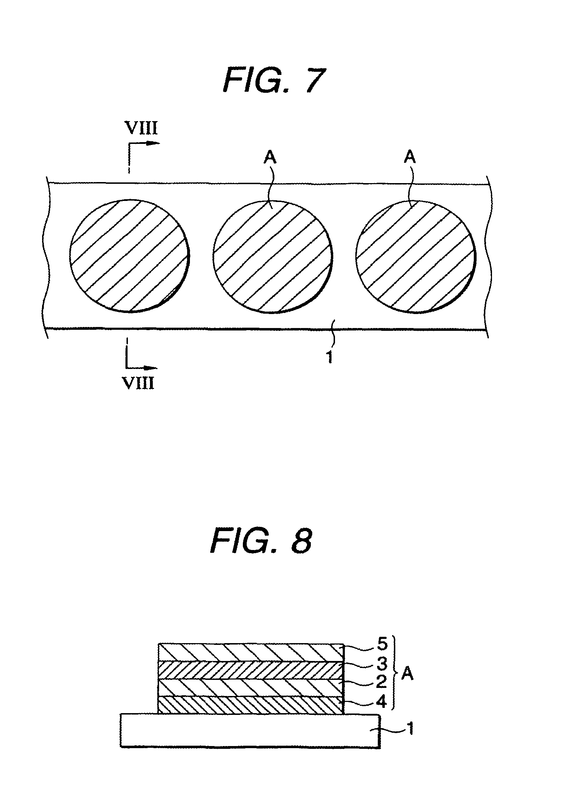

Fig. 7 shows an example of a label sheet for cleaning which is to be used for the conveying member having a cleaning function according to the invention wherein a plurality of labels A for cleaning are continuously provided on an elongated separator 1 at regular intervals. The shape of the label A is smaller than that of the conveying member W of Fig. 6. The label A includes a cleaning layer 3 on one of surfaces of a base material 2, a separating film 5 on a surface thereof, and an ordinary adhesive layer 4 on the other surface as shown in Fig. 8 (a sectional view taken along a line VIII - VII I in Fig. 7) and is removaly provided on the separator 1 through the adhesive layer 4.

During use, the label A for cleaning is removed from the separator 1 and is bonded to the conveying member W such as a semiconductor wafer, and furthermore, the separating film 5 is removed and the label A for cleaning is thus conveyed into an equipment. Consequently, a portion to be washed can be cleaned.

Moreover, the shape of the label A is not particularly restricted if it is smaller than the shape of the conveying member W, and a circular shape, a wafer shape and a frame shape can be taken depending on the shape of the conveying member such as a substrate to be bonded, for example.

While the invention will be described below based on embodiments, the invention is not restricted thereto. In the following description, a "part" represents a "part by weight". First Embodiment

50 parts by weight of polyethyleneglycol dimethacrylate, 50 parts by weight of urethane acrylate, 3 parts by weight of benzyldimethyl ketal and 3 parts by weight of diphenylmethane diisocyanate were uniformly mixed with 100 parts by weight of acryl based polymer (a weight average molecular weight of 700000) obtained by a monomer mixed solution containing 75 parts by weight of acrylic acid - 2 - ethylhexyl, 20 parts by weight of methyl acrylate and 5 parts by weight of acrylic acid and an adhesive solution of an ultraviolet curing type was thus prepared.

On the other hand, an ordinary adhesive solution was prepared in the same manner as described above except that the benzyldimethyl ketal was excluded from the adhesive.

The ordinary adhesive solution was coated to have a thickness of 10 *µ*m after drying over the removed surface of a separator formed of an elongated polyester film (a thickness of 38 *µ*m, a width of 250 mm) having one of surfaces treated with a silicone based remover, an elongated polyolefin film (a thickness of 25 µm, a width of 250 mm) was provided on an adhesive layer, and furthermore, an adhesive solution of an ultraviolet curing type was coated over the film to have a thickness of 40 *µ*m after drying. Thus, a sheet was obtained.

Ultraviolet rays having a central wavelength of 365 nm were irradiated on the sheet with an integral light quantity of 1000 mJ/cm² so that a sheet for cleaning having a cleaning layer cured by the ultraviolet rays was obtained.

An adhesive film to be a laminator other than the separator of the sheet for cleaning was punched like a circle having a diameter of 200 mm, and an unnecessary adhesive film was continuously separated and removed. Thus, the label sheet for cleaning according to the invention shown in Fig. 1 was fabricated.

A cleaning layer of the cleaning sheet was bonded to the mirror surface of a silicon wafer with a width of 10 mm and a 180° peeling adhesion to the silicon wafer was measured in accordance with JIS 20237. As a result, a 180° peeling adhesion of 0.078 N / 10 mm was obtained.

The cleaning layer of the cleaning sheet had a modulus of tensile elasticity of 49 N /mm². The modulus of tensile elasticity was measured in accordance with a test method JIS K7127.

Moreover, a surface resistivity was measured over the cleaning layer with a surface resistivity measuring equipment (produced by Mitsubishi Chemical Corporation, Type of MCP - UP450) at a temperature of 23°C and a humidity of 60 % RH. As a result, 9.99 x 10¹³Q /□ or more was obtained and the measurement could not be carried out.

The label for cleaning was removed from the separator of the label sheet for cleaning thus obtained and was bonded to the back face (mirror surface) of the silicon wafer having a size of 8 inches with a hand roller. Thus, a cleaning wafer for conveyance having a cleaning function was fabricated.

On the other hand, two wafer stages of the substrate processing equipment were removed and foreign matters having a size of 0.3 µm or more were measured through a laser type foreign matter measuring equipment. Consequently, there were 20000 foreign matters in an area having a wafer size of 200 mm (8 inches) and 18000 foreign matters in another area.

Next, a removing film on the cleaning layer side of the cleaning wafer for conveyance obtained as described above was removed and was conveyed into the substrate processing equipment having a wafer stage to which the 20000 foreign matters stuck. The conveyance could be carried out without a hindrance. Then, the wafer stage was removed and the foreign matters having a size of 0.3 µm or more were measured through the laser type foreign matter measuring equipment. As a result, there were 3950 foreign matters within a wafer size of 200 mm (8 inches) and 3/4 of the foreign matters or more which stuck before the cleaning could be removed.

### Comparative Example 1

A cleaning sheet was fabricated in the same manner as that in the first embodiment except that ultraviolet rays having a central wavelength of 365 nmwere irradiated with an integral light quantity of 150 mJ/cm². An adhesion to a silicon wafer was measured. As a result, an adhesion of 0.33 N / 10 mm was obtained.

A cleaning wafer for conveyance which was fabricated from the cleaning sheet in the same method as that in the embodiment was conveyed into a substrate processing equipment having a wafer stage to which 18000 foreign matters stuck. As a result, the cleaning wafer was fastened to the wafer stage and could not be conveyed.

### Second Embodiment

50 parts by weight of polyethyleneglycol 200 dimethacrylate (produced by SHIN - NAKAMURA CHEMICAL CO., LTD : trade name of Nk Ester 4G), 50 parts by weight of urethane acrylate (produced by SHIN - NAKAMURA CHEMICAL CO., LTD : trade name of U-N-01), 3 parts by weight of polyisocyanate compound (produced by NIPPON POLYURETHANE INDUSTRY CO., LTD : trade name of Colonate L) and 3 parts by weight of benzyldimethyl ketal as a photopolymerization initiator (produced by CIBA SPECIALTY CHEMICALS K.K. : trade name of Irugacure - 651) were uniformly mixed with 100 parts by weight of acryl basedpolymer (a weight average molecular weight of 700000) obtained by a monomer mixed solution containing 75 parts by weight of acrylic acid - 2 - ethylhexyl, 20 parts by weight of methyl acrylate and 5 parts by weight of acrylic acid and an adhesive solution of an ultraviolet curing type was thus prepared.

On the other hand, an ordinary adhesive solution was obtained in the same manner as described above except that the benzyldimethyl ketal was excluded from the adhesive.

The ordinary adhesive solution was coated to have a thickness of 10 *µ*m after drying over the removed surface of a separator formed of an elongated polyester film (a thickness of 38 *µ*m, a width of 250 mm) having one of surfaces treated with a silicone based remover, an elongated polyester film (a thickness of 25 µm, a width of 250 mm) was provided on the adhesive layer, and furthermore, an adhesive solution of an ultraviolet curing type was coated over the film to have a thickness of 40 *µ*m after drying. Thus, an adhesive layer was provided as a cleaning layer, and the removed surface of a removing film formed of the elongated polyester film (a thickness of 38 µm, a width of 250 mm) having one of surfaces treated with a silicone based remover was bonded to the surface of the adhesive layer. Thus, a sheet was obtained.

Ultraviolet rays having a central wavelength of 365 nm were irradiated on the sheet with an integral light quantity of 1000 mJ/cm² so that a sheet for cleaning having a cleaning layer cured by the ultraviolet rays was obtained.

An adhesive film to be a laminator other than the separator of the sheet for cleaning was punched like a circle having a diameter of 198 mm and the sheet was thus cut. Consequently, an unnecessary adhesive film was continuously separated and removed. Thus, the label sheet for cleaning according to the invention shown in Fig. 7 was fabricated. Moreover, the cleaning layer of the label sheet for cleaning had a modulus of tensile elasticity of 49 N/ mm² after the curing through the irradiation of the ultraviolet rays. The modulus of tensile elasticity was measured in accordance with a test method JIS K7127.

The label for cleaning was removed from the separator of the label sheet for cleaning thus obtained and was bonded to the back face (mirror surface) of a silicon wafer having a size of 200 mm (8 inches) (200 mm) with a hand roller. Thus, a cleaning wafer for conveyance having a cleaning function was fabricated.

By using the label sheet for cleaning, the label was bonded to the back face (mirror surface) of,the silicon wafer having a size of 200 mm (8 inches) through a label tape bonding machine (produced by NITTO SEIKI INC. : trade name of NEL-GR3000) . This operation was carried out continuously for 25 sheets. As a result, the sheet could be bonded to the wafer without a problem. Thus, a cleaning wafer for conveyance having a cleaning function couldbe fabricated. Moreover, the cleaning wafer for conveyance having a cleaning function thus obtained was confirmed, and it was found that all the label sheets are bonded to the inside of the silicon wafer and were not protruded from the end of the wafer.

Moreover, the cleaning layer was bonded to the mirror surface of the silicon wafer with a width of 10 mm and a 180° peeling adhesion to the silicon wafer was measured in accordance with JIS Z0237. As a result, the 180° peeling adhesion to the silicon wafer was 0.078 N / 10 mm.

On the other hand, foreign matters having a size of 0.2 *µ*m or more were measured over the mirror surfaces of two brand-new silicon wafers having a size of 200 mm (8 inches) through a laser type foreign matter measuring equipment. Consequently, a first wafer had six foreign matters and a second wafer had five foreign matters. After the wafers are conveyed to a substrate processing equipment having separate electrostatic adsorbing mechanisms with the mirror surfaces put on the underside and the foreign matters having a size of 0.2 µm or more were measured through the laser type foreign matter measuring equipment. Consequently, a first wafer had 33456 foreign matters in an area having a wafer size of 200 mm (8 inches) and a second wafer had 36091 foreign matters.

Next, a removing film on the cleaning layer side of the cleaning wafer for conveyance obtained as described above was removed and was conveyed into the substrate processing equipment having a wafer stage to which the 33456 foreign matters stuck. The conveyance couldbe carried out without a hindrance. Then, a brand-new silicon wafer having a size of 8 inches was conveyed with a mirror surface put on the underside and foreign matters having a size of 0.2 µm or more were measured through the laser type foreign matter measuring equipment. This operation was carried out five times and a ratio of foreign matter removal is shown in Table 1.

**Table 1**

| | Ratio of foreign matter removal | | | | |
|---|---|---|---|---|---|
| | 1 sheet conveyance | 2 sheets conveyance | 3 sheets conveyance | 4 sheets conveyance | 5 sheets conveyance |
| Second embodiment | 80% | 88% | 90% | 92% | 92% |

### Comparative Example 2

A cleaning wafer for conveyance having a cleaning function was fabricated in the same manner as that in the second embodiment except that a label sheet for cleaning obtained through punching into a circular shape having a diameter of 202 mm was used. The wafer was confirmed through a microscope and it was found that the label sheet for cleaning was protruded from the outer peripheral portion of the silicon wafer.

A separating film on the cleaning layer side of the cleaning wafer for conveyance was removed and was set onto a wafer cassette to be conveyed into a substrate processing equipment. Consequently, the protruded label sheet came in contact with the internal wall of the cassette and the cleaning wafer itself for conveyance was shifted from a regular position in the wafer cassette. Therefore, the conveyance could not be carried out. Accordingly, the conveyance using the cleaning wafer for conveyance was stopped. Third Embodiment

50 parts by weight of polyethyleneglycol 200 dimethacrylate (produced by SHIN - NAKAMURA CHEMICAL CO., LTD : trade name of Nk Ester 4G), 50 parts by weight of urethane acrylate (produced by SHIN - NAKAMURA CHEMICAL CO., LTD : trade name of U-N-01), 3 parts by weight of polyisocyanate compound (produced by NIPPON POLYURETHANE INDUSTRY CO., LTD : trade name of Colonate L) and 3 parts by weight of benzyldimethyl ketal as a photopolymerization initiator (produced by CIBA SPECIALTY CHEMICALS K.K. : trade name of Irugacure - 651) were uniformly mixed with 100 parts by weight of acryl based polymer (a weight average molecular weight of 700000) obtained by a monomer mixed solution containing 75 parts by weight of acrylic acid - 2 - ethylhexyl, 20 parts by weight of methyl acrylate and 5 parts by weight of acrylic acid and an adhesive solution of an ultraviolet curing type was thus prepared.

On the other hand, an ordinary adhesive solution was obtained in the same manner as described above except that the benzyldimethyl ketal was excluded from the adhesive.

The ordinary adhesive solution was coated to have a thickness of 10 µ m after drying over the removed surface of a separator formed of an elongated polyester film (a thickness of 38 µm, a width of 250 mm) having one of surfaces treated with a silicone based remover, an elongated polyester film (a thickness of 25 µm, a width of 250 mm) was provided on the adhesive layer, and furthermore, an adhesive solution of an ultraviolet curing type was coated over the film to have a thickness of 40 *µ*m after drying. Thus, an adhesive layer was provided as a cleaning layer, and the removed surface of a removing film formed of the elongated polyester film (a thickness of 38 µm, a width of 250 mm) having one of surfaces treated with a silicone based remover was bonded to the surface of the adhesive layer. Thus, a sheet was obtained.

Ultraviolet rays having a central wavelength of 365 nm were irradiated on the sheet with an integral light quantity of 1000 mJ/cm² so that a sheet for cleaning having a cleaning layer cured by the ultraviolet rays was obtained.

An adhesive film to be a laminator other than the separator of the sheet for cleaning was punched like a circle having a diameter of 200 mm and the sheet was thus cut. Consequently, an unnecessary adhesive film was continuously separated and removed. Thus, the label sheet for cleaning according to the invention shown in Fig. 1 was fabricated. The processing of punching the cleaning sheet could be carried out without generation of adhesive roping and a cut refuse. After the fabrication, the label sheet was observed and it was found that the adhesive was not protruded from the end of the label and the label was not contaminated by the adhesive.

Moreover, the cleaning layer of the sheet for cleaning had a modulus of tensile elasticity of 49 N/ mm² after the curing through the irradiation of the ultraviolet rays, that is, the sheet punching. The modulus of tensile elasticity was measured in accordance with a test method JIS K7127.

The label for cleaning was removed from the separator of the label sheet having a cleaning function thus obtained and was bonded to the back face (mirror surface) of a silicon wafer having a size of 8 inches with a hand roller. Thus, a cleaning wafer for conveyance having a cleaning function was fabricated.

By using the label sheet having a cleaning function, the label was bonded to the back face (mirror surface) of the silicon wafer having a size of 200 mm (8 inches) through a label tape bonding machine (produced by NITTO SEIKI INC. : trade name of NEL-GR3000). This operation was carried out continuously for 25 sheets. As a result, the sheet could be bonded to the wafer without a problem. Thus, a cleaning wafer for conveyance having a cleaning function could be fabricated. Moreover, the cleaning layer was bonded to the mirror surface of the silicon wafer with a width of 10 mm and a 180° peeling adhesion to the silicon wafer was measured in accordance with JIS Z0237. As a result, the 180° peeling adhesion to the silicon wafer was 0.078 N / 10 mm.

On the other hand, foreign matters having a size of 0.2 µm or more were measured over the mirror surfaces of two brand-new silicon wafers having a size of 8 inches through a laser type foreign matter measuring equipment. Consequently, a first wafer had six foreign matters and a second wafer had five foreign matters. After the wafers are conveyed to a substrate processing equipment having separate electrostatic adsorbing mechanisms with the mirror surfaces put on the underside and the foreign matters having a size of 0.2µ m or more were measured through the laser type foreign matter measuring equipment. Consequently, a first wafer had 33456 foreign matters in an area having a wafer size of 200 mm (8 inches) and a second wafer had 36091 foreign matters.

Next, a removing film on the cleaning layer side of the cleaning wafer for conveyance obtained as described above was removed and was conveyed into the substrate processing equipment having a wafer stage to which the 33456 foreign matters stuck. The conveyance couldbe carried out without a hindrance. Then, a brand-new silicon wafer having a size of 200 mm (8 inches) was conveyed with a mirror surface put on the underside and foreign matters having a size of 0.2 *µ*m or more were measured through the laser type foreign matter measuring equipment. This operation was carried out five times and a ratio of foreign matter removal is shown in Table 2.

**Table 2**

| | Ratio of foreign matter removal | | | | |
|---|---|---|---|---|---|
| | 1 sheet conveyance | 2 sheets conveyance | 3 sheets conveyance | 4 sheets conveyance | 5 sheets conveyance |
| Third embodiment | 80% | 88% | 90% | 92% | 92% |

### Comparative Example 3

A cleaning sheet was fabricated in the same manner as that in the third embodiment except that ultraviolet rays having a central wavelength of 365 nm were not irradiated on the cleaning sheet with an integral light quantity of 1000 mJ/cm². The sheet was cut through punching into a circular shape having a diameter of 200 mm in the same manner as that in the embodiment. Thus, a label sheet having a cleaning function was fabricated. In this case, since the cleaning layer was not cured, it served as a cushioning material. Consequently, a punching depth was not uniform so that a large number of punching defects of the label were generated. Moreover, the label thus fabricated was observed and it was found that an adhesive leaked out of the end of the label. Furthermore, many portions on the label were contaminated by the adhesive due to adhesive roping during the punching. In particular, moreover, the adhesive stuck onto a removing film around the cleaning layer side at the end of the label. After the label was fabricated, the ultraviolet rays having a central wavelength of 365 nm were irradiated with an integral light quantity of 1000 mJ/cm². However, the adhesive on the end of the label was not cured due to oxygen inhibition but had tackiness. Accordingly, the fabrication of a cleaning wafer for conveyance using the label sheet was stopped.

### Industrial Applicability

According to the cleaning sheet of the invention, as described above, conveyance in a substrate processing equipment can be carried out reliably and foreign matters sticking into the equipment can be removed easily and reliably. Furthermore, since sheet cutting is not required after bonding to a substrate, a working efficiency can be enhanced and a cut refuse is not generated.

## Claims

1. A label sheet for cleaning a substrate processing equipment comprising:
a label (A) for cleaning including a cleaning layer (3) having a 180° peeling adhesion to a mirror surface of a silicon wafer of 0.20 N / 10 mm or less after receiving an active energy and an adhesive layer (4) provided on one of the surfaces of said cleaning layer (3); and
a separator (1) on which said label is removably provided through said adhesive layer (4).

2. A label sheet for cleaning according to claim 1, further comprising a base material (2), said label being provided on one of surfaces of said base material (2) and said adhesive layer (4) being provided on the other surface of said base material (2).

3. A label sheet for cleaning according to claim 1, wherein a plurality of labels (A) are continuously provided on an elongated separator (1) at regular intervals.

4. A label sheet for cleaning according to claim 1, wherein a reinforcing portion is formed through a concave portion around the label (A) for cleaning.

5. A label sheet for cleaning according to claim 4, wherein the concave portion is provided like a trench over at least a whole periphery of the label (A) for cleaning.

6. A label sheet for cleaning according to claim 4, wherein the reinforcing portion is formed like a band on both ends of the separator (1).

7. A label sheet for cleaning according to claim 6, wherein the band-shaped reinforcing portion on at least one of the sides is not provided in contact with the label (A) for cleaning.

8. A label sheet for cleaning according to any of claims 1 - 7, wherein the label (A) for cleaning and/or the reinforcing portion are/is formed by punching an adhesive film in each shape which comprises a base material (2), said cleaning layer (3) and an ordinary adhesive layer (4) and by removing the unnecessary adhesive film (4).

9. A conveying member (W) having a cleaning function comprising a label sheet according to one of claims 1-8, for cleaning on the conveying member (W), wherein the label sheet for cleaning has a smaller shape than that of the conveying member (W) and is not protruded from an end of the conveying member (W).

10. A label sheet for cleaning according to one of claims 1 - 8 to be used in the conveying member (W) having a cleaning function according to claim 9, wherein a cleaning layer (3) is provided on one of the surfaces of a base material (2) with a surface thereof protected by a removing film and the other surface is removably provided on a separator (1) through an ordinary, adhesive layer (4).

11. A label sheet for cleaning according to claim 10, wherein a plurality of labels (A) for cleaning are continuously provided on an elongated separator (1) at intervals.

12. A conveying member (W) having a cleaning function and the label sheet for cleaning according to claim 10, wherein the cleaning layer (3) is a curing type adhesive which is polymerized and cured upon receipt of an active energy.

13. A conveying member (W) having a cleaning function according to claim 9 and the label sheet for cleaning according to claims 10-11, wherein the cleaning layer (3) has a modulus of tensile elasticity of 10 N/mm² or more in accordance with JIS K7127.

14. A method of cleaning a substrate processing equipment wherein the conveying member (W) having a cleaning function according to claim 9 is conveyed into the substrate processing equipment.

15. A method of manufacturing a label sheet according to one of claims 1-8 for cleaning in which a cleaning layer (3) formed of an adhesive is provided on one of the surfaces of a base material thereof (2) protected by a removing film and the other surface is removably provided on a separator (1) through an ordinary adhesive layer (4), wherein the cleaning layer (3) is a curing type adhesive which is polymerized and cured upon receipt of an active energy and the sheet punching process to have a shape of the label (A) is carried out after a polymerization and curing reaction of the adhesive of the cleaning layer (3).

16. A method of manufacturing a label sheet for cleaning according to claim 15, wherein the cleaning layer (3) has a modulus of tensile elasticity of 10 N/mm² or more in accordance with JIS K7127 during label forming punching process of the sheet.

## Patentansprüche

1. Etikettenblatt zum Reinigung einer Substratbearbeitungsstation mit: einem Reinigungsetikett (A), enthaltend eine Reinigungsschicht (3) mit 180° Haftfestigkeit von nicht mehr als 0,20 N/10 mm gegenüber einer Spiegeloberfläche eines Silicium-Wafers nach Empfang einer aktiven Energie und mit einer auf einer der Oberflächen der Reinigungsschicht vorgesehenen Klebeschicht (4); und einem Separator (1), auf welchem das Etikett mittels der Klebstoffschicht (4) ablösbar angeordnet ist.

2. Etikettenblatt zum Reinigen nach Anspruch 1, ferner enthaltend ein Trägermaterial (2), wobei das Reinigungsetikett auf einer der Oberflächen des Trägermaterials (2) angeordnet ist und die Klebeschicht (4) auf der anderen Oberfläche des Trägermaterials (2) angeordnet ist.

3. Etikettenblatt zum Reinigen nach Anspruch 1, wobei eine Vielzahl von Reinigungsetiketten (A) fortlaufend auf einem länglichen Separator (1) in regelmäßigen Abständen angeordnet ist.

4. Etikettenblatt zum Reinigen nach Anspruch 1, wobei ein Verstärkungsabschnitt ausgebildet ist mit Hilfe eines Rings um das Reinigungsetikett (A) verlaufenden konkaven Abschnittes.

5. Etikettenblatt zum Reinigen nach Anspruch 4, wobei der konkave Abschnitt wie ein Graben über wenigstens den gesamten Umfang des Reinigungsetikettes (A) vorgesehen ist.

6. Etikettenblatt zum Reinigen nach Anspruch 4, wobei der Verstärkungsabschnitt wie ein Band an beiden Enden des Separators (1) ausgebildet ist.

7. Etikettenblatt zum Reinigen nach Anspruch 6, wobei der bandförmige Verstärkungsabschnitt auf wenigstens einer der Seiten nicht in Kontakt mit dem Reinigungsetikett (A) vorgesehen ist.

8. Etikettenblatt zum Reinigen nach einem der Ansprüche 1 bis 7, wobei das Reinigungsetikett (A) und/oder der Verstärkungsabschnitt ausgebildet sind/ist durch Ausstanzen eines Klebebandes jedweder Gestalt, welches ein Trägermaterial (2), die Reinigungsschicht (3) und eine gewöhnliche Klebstoffschicht (4) umfasst, und durch Entfernen des nicht benötigten Klebstofffilms (4).

9. Förderelement (W) mit Reinigungsfunktion, umfassend ein Etikettenblatt zum Reinigen nach einem der Ansprüche 1 bis 8 auf dem Förderelement (W), wobei das Etikettenblatt zum Reinigen einen kleineren Umriss hat als das Förderelement (W) und nicht über ein Ende des Förderelementes (W) vorsteht.

10. Etikettenblatt zum Reinigen nach einem der Ansprüche 1 bis 8 zur Verwendung mit dem Förderelement (W) mit Reinigungsfunktion nach Anspruch 9, wobei eine Reinigungsschicht (3) auf einer der Oberflächen eines Trägermaterials (2) vorgesehen ist, dessen eine Oberfläche mit Hilfe eines Ablösefilms geschützt ist und dessen andere Oberfläche mit Hilfe einer gewöhnlichen Klebstoffschicht (4) ablösbar auf einem Separator (1) vorgesehen ist.

11. Etikettenblatt zum Reinigen nach Anspruch 10, wobei eine Vielzahl von Reinigungsetiketten (A) fortlaufend auf einem länglichen Separator (1) im Abstand voneinander vorgesehen ist.

12. Förderelement (W) mit Reinigungsfunktion und Etikettenband zum Reinigen nach Anspruch 10, wobei die Reinigungsschicht (3) aus einem härtbaren Klebstoff besteht, welcher nach Empfang einer aktiven Energie polymerisiert und gehärtet ist.

13. Förderelement (W) mit Reinigungsfunktion nach Anspruch 9 und Etikettenband zum Reinigen nach den Ansprüchen 10 bis 11, wobei die Reinigungsschicht (3) einen Elastizitätsmodul von wenigstens 10 N/mm² gemäß JIS K7127 aufweist.

14. Verfahren zum Reinigen einer Substratbearbeitungsstation, bei welchem das Förderelement (W) mit Reinigungsfunktion gemäß Anspruch 9 in die Substratbearbeitungsstation gefördert wird.

15. Verfahren zum Herstellen eines Etikettenblattes zum Reinigen nach einem der Ansprüche 1 bis 8, bei welchem eine aus einem Klebstoff bestehende Reinigungsschicht (3) auf einer durch einen Ablösefilm geschützten Oberfläche eines Trägermaterials (2) ausgebildet wird und die andere Oberfläche mittels einer gewöhnlichen Klebstoffschicht (4) ablösbar auf einem Separator (1) angeordnet wird, wobei die Reinigungsschicht (3) aus einem härtbaren Klebstoff besteht, welcher durch Empfang einer aktiven Energie polymerisiert und gehärtet wird, und bei welchem das Etikettenblatt einem Stanzvorgang zum Erzielen der Umrissgestalt des Reinigungsetikettes (A) unterworfen wird, nachdem die Polymerisations- und Härtereaktion des Klebstoffes der Reinigungsschicht (3) erfolgt ist.

16. Verfahren zum Herstellen eines Etikettenblattes zum Reinigen nach Anspruch 15, bei welchem die Reinigungsschicht (3) während des Etiketten formenden Stanzschrittes einen Elastizitätsmodul von wenigstens 10 N/mm² gemäß JIS K7127 aufweist.

## Revendications

1. Feuille d'étiquette destinée à nettoyer un équipement de traitement de substrat comprenant :
une étiquette (A) pour le nettoyage comportant une couche nettoyante (3) présentant une résistance au pelage à 180° d'une une surface spéculaire d'une plaquette en silicium de 0,20 N/10 mm ou moins après avoir reçu une énergie active et une couche adhésive (4) prévue sur une des surfaces de ladite couche nettoyante (3) ; et
un séparateur (1) sur lequel ladite étiquette est prévue de manière amovible à travers ladite couche adhésive (4).

2. Feuille d'étiquette de nettoyage selon la revendication 1, comprenant en outre un matériau de base (2), ladite étiquette étant prévue sur une des surfaces dudit matériau de base (2) et ladite couche adhésive (4) étant prévue sur l'autre surface dudit matériau de base (2).

3. Feuille d'étiquette de nettoyage selon la revendication 1, dans laquelle une pluralité d'étiquettes (A) sont prévues en continu sur un séparateur allongé (1) à intervalles réguliers.

4. Feuille d'étiquette de nettoyage selon la revendication 1, dans laquelle une partie de renforcement est formée à travers une partie concave autour de l'étiquette (A) pour le nettoyage.

5. Feuille d'étiquette de nettoyage selon la revendication 4, dans laquelle la partie concave est prévue comme un puits au-dessus d'au moins toute une périphérie de l'étiquette (A) pour le nettoyage.

6. Feuille d'étiquette selon la revendication 4, dans laquelle la partie de renforcement est formée comme une bande sur les deux extrémités du séparateur (1).

7. Feuille d'étiquette de nettoyage selon la revendication 6, dans laquelle la partie de renforcement en forme de bande sur au moins un des côtés n'est pas prévue en contact avec l'étiquette (A) pour le nettoyage.

8. Feuille d'étiquette pour le nettoyage selon l'une quelconque des revendications 1 à 7, dans laquelle l'étiquette (A) pour le nettoyage et/ou la partie de renforcement sont/est formée(s) en perforant un film adhésif dans chaque forme qui comprend un matériau de base (2), ladite couche nettoyante (3) et une couche adhésive ordinaire (4) et en retirant le film adhésif (4) inutile.

9. Elément de transport (W) présentant une fonction nettoyante comprenant une feuille d'étiquette selon l'une quelconque des revendications 1 à 8, pour le nettoyage sur l'élément de transport (W), dans lequel la feuille d'étiquette de nettoyage présente une forme inférieure à celle de l'élément de transport (W) et ne dépasse pas d'une extrémité de l'élément de transport (W).

10. Feuille d'étiquette de nettoyage selon l'une quelconque des revendications 1 à 8 à utiliser dans l'élément de transport (W) présentant une fonction nettoyante selon la revendication 9, dans laquelle une couche nettoyante (3) est prévue sur une des surfaces d'un matériau de base (2) avec une de ses surfaces protégée par un film amovible et l'autre surface est prévue de manière amovible sur un séparateur (1) à travers une couche adhésive ordinaire (4).

11. Feuille d'étiquette de nettoyage selon la revendication 10, dans laquelle une pluralité d'étiquettes (A) de nettoyage sont prévues en continu sur un séparateur allongé (1) à intervalles.

12. Elément de transport (W) présentant une fonction nettoyante et la feuille d'étiquette de nettoyage selon la revendication 10, dans lequel la couche nettoyante (3) est un adhésif du type à cuisson qui est polymérisé et cuit lorsqu'il reçoit une énergie active.

13. Elément de transport (W) présentant une fonction nettoyante selon la revendication 9 et la feuille d'étiquette de nettoyage selon l'une quelconque des revendications 10 à 11, dans lequel la couche nettoyante (3) présente un module d'élasticité à la traction de 10 N/mm² ou plus conformément à la norme JIS K7127.

14. Procédé de nettoyage d'un équipement de traitement de substrat dans lequel l'élément de transport (W) présentant une fonction nettoyante selon la revendication 9 est transporté à l'intérieur de l'équipement de traitement de substrat.

15. Procédé de fabrication d'une feuille d'étiquette selon l'une quelconque des revendications 1 à 8 de nettoyage dans lequel une couche nettoyante (3) formée à partir d'un adhésif est prévue sur une des surfaces d'un matériau de base de celle-ci (2) protégée par un film amovible et l'autre surface est prévue de manière amovible sur un séparateur (1) à travers une couche adhésive ordinaire (4), dans lequel la couche nettoyante (3) est un adhésif de type à cuisson qui est polymérisé et cuit en recevant une énergie active et le processus de perforation de feuille pour présenter une forme de l'étiquette (A) est réalisé après une réaction de polymérisation et de cuisson de l'adhésif de la couche nettoyante (3).

16. Procédé de fabrication d'une feuille d'étiquette de nettoyage selon la revendication 15, dans lequel la couche nettoyante (3) présente un module d'élasticité à la traction de 10 N/mm² ou plus conformément à la norme JIS K7127 pendant le processus de perforation et de formation d'étiquette de la feuille.
